Europäisches Patentamt

European Patent Office

Office européen des brevets

(11) Veröffentlichungsnummer: **0 134 822**
**B1**

# (12) EUROPÄISCHE PATENTSCHRIFT

(45) Veröffentlichungstag der Patentschrift:
20.07.88

(21) Anmeldenummer: **83107386.1**

(22) Anmeldetag: **27.07.83**

(51) Int. Cl.⁴: **G 11 C 8/00,** G 11 C 11/24,
G 11 C 5/06, G 06 F 12/00

(54) **Digitalspeicher.**

(43) Veröffentlichungstag der Anmeldung:
**27.03.85 Patentblatt 85/13**

(45) Bekanntmachung des Hinweises auf die Patenterteilung:
**20.07.88 Patentblatt 88/29**

(84) Benannte Vertragsstaaten:
**DE FR GB**

(56) Entgegenhaltungen:
DE-A-2 635 028

**PATENTS ABSTRACTS OF JAPAN, Band 3, Nr. 26(E-95), 6. März 1979, Seite 9E95
PATENTS ABSTRACTS OF JAPAN; Band 4, Nr. 100(P-19)(582), 18. Juli 1980**

(73) Patentinhaber: **IBM DEUTSCHLAND GMBH, Pascalstrasse 100, D-7000 Stuttgart 80 (DE)**
(84) Benannte Vertragsstaaten: **DE**

(73) Patentinhaber: **International Business Machines Corporation, Old Orchard Road, Armonk, N.Y. 10504 (US)**
(84) Benannte Vertragsstaaten: **FR GB**

(72) Erfinder: **Meyers, Richard, Ing., Talstrasse 54, D-7032 Sindelfingen (DE)**
Erfinder: **Rossi, Francis, Ing., Strassburger Strasse 13, D-7030 Böblingen (DE)**
Erfinder: **Strähle, Werner, Dipl.- Ing., Lärchenstrasse 19, D-7405 Dettenhausen (DE)**

(74) Vertreter: **Teufel, Fritz, Dipl.- Phys., IBM Deutschland GmbH. Europäische Patentdienste Postfach 265, D-8000 München 22 (DE)**

**Beschreibung**

Die Erfindung betrifft einen Digitalspeicher nach dem Oberbegriff des Hauptanspruchs.

Die Leistungsfähigkeit moderner Datenverarbeitungsanlagen wird zu einem großen Teil durch die Digitalspeicher bestimmt, in denen die Programme und die zu verarbeitenden Daten enthalten sind. Idealerweise müßte ein Digitalspeicher eine sehr hohe Kapazität, sehr kurze Zugriffszeit und eine sehr hohe Datenrate für das Einschreiben und Auslesen aufweisen und zu einem möglichst günstigen Preis herstellbar sein. In der Realität lassen sich diese Anforderungen bei einem bestimmten Speichertyp jedoch nicht gleichzeitig erfüllen; schnelle Speicher, wie sie beispielsweise die bipolare Halbleitertechnologie zur Verfügung stellt, sind relativ teuer, während billige Speicher im allgemeinen langsam arbeiten. Bei allen bekannten Speichertypen sinkt außerdem die Arbeitsgeschwindigkeit, wenn die Gesamtkapazität eines Speichersystems vergrößert wird.

Zur Behebung dieser Schwierigkeit wurden schon vielfältige Vorschläge gemacht und realisiert, wie Speicher verschiedener Technologien und unterschiedlicher Charakteristiken in einem Speichersystem zusammengefaßt werden können, um dessen Charakteristik in der gewünschten Weise zu verbessern. Beispiele für derartige Speichersysteme sind bei der sogenannten virtuellen Adressierung zu finden, bei der im schnellen Hauptspeicher einer Datenverarbeitungsanlage nur die jeweils aktuellen Daten enthalten sind, während die gerade nicht benötigten Daten auf Plattenspeichern abgelegt werden; ein weiteres Beispiel sind sogenannte Pufferspeicherarchitekturen (Cache-Systeme), bei denen zwischen dem Hauptspeicher und dem Prozessor einer Datenverarbeitungsanlage ein schneller Pufferspeicher vorgesehen ist, der vollautomatisch verwaltet wird und die jeweils aktiven Daten und Instruktionen enthält. Weitere Beispiele zur Leistungserhöhung einer Datenverarbeitungsanlage durch Einsatz verschiedener Speichertypen sind die Verwendung von sogenannten lokalen Speichern innerhalb eines Prozessors (zur Aufnahme von Registern oder Zwischenergebnissen) oder der Anschluß verschiedener Speichertypen an eine gemeinsame Speichersammelleitung, ein Beispiel für die letztgenannte Konfiguration ist in JP-A-54 40 27 zu finden.

Zum Aufbau derartiger Speicherhierarchien ist jedoch ein relativ großer Aufwand an Steuerschaltungen und interner Verwaltung nötig, so daß ihr Einsatz nur bei großer Gesamtkapazität in Frage kommt. Ein naturgegebener Nachteil besteht auch darin, daß die in einem Speicher enthaltenen Daten zum Teil in einem anderen Speicher dupliziert werden, so daß ein gewisser Teil der Gesamtkapazität des Speichersystems nicht effektiv ausgenutzt ist. Bei vielen Speicherhierarchien bleiben außerdem noch Wünsche im Hinblick auf die erreichte Effektivität offen, da nicht alle Leistungsmängel eines Speichertyps ohne weiteres ausgeglichen werden können. Beispielsweise erfordern Cache-Systeme einen Hauptspeicher mit einem schnellen ersten Zugriff während einer Blockübertragung, um bei einem im Cache-Speicher auftretenden Fehltreffer möglichst schnell die gewünschten Daten vom Hauptspeicher zum Prozessor (und gleichzeitig in den Cache) übertragen zu können; außerdem ist eine sehr hohe Datenrate erforderlich, um den Cache-Speicher schnell laden zu können. Bei den für moderne Cache-Systeme verwendeten großen Hauptspeichern (bis zu einigen Megabytes) ist außerdem auf einen möglichst günstigen Herstellpreis für den Hauptspeicher zu achten.

Die vorliegende Erfindung stellt sich daher die Aufgabe, einen Digitalspeicher der eingangs genannten Art anzugeben, der bei möglichst geringen Herstellkosten eine hohe Leistungsfähigkeit aufweist und insbesondere für den Einsatz innerhalb einer Speicherhierarchie geeignet ist.

Diese Aufgabe wird durch die im Anspruch 1 gekennzeichnete Erfindung gelöst; Ausgestaltungen der Erfindung sind in den Unteransprüchen gekennzeichnet.

Eine besondere Verwendung dieses Digitalspeichers ist in Anspruch 10 gekennzeichnet.

Die Erfindung geht von der Erkenntnis aus, daß bei vielen Anwendungen die Daten nicht in einzelnen Wörtern (oder Teilen davon) übertragen werden, sondern in Blöcken, die jeweils aus einer Vielzahl von Wörtern (oder Bytes) bestehen. Die Adressen des jeweils ersten Datenelements der Blöcke können dabei nicht willkürlich gewählt werden, sondern müssen auf sogenannten Adreßgrenzen liegen, so daß die Adressen aller Blockanfänge in ihrer Gesamtheit bekannt sind. Die Erfindung schlägt nun vor, einen Digitalspeicher, der beispielsweise als Hauptspeicher in einer Speicherhierarchie eingesetzt werden soll, so aufzubauen, daß verschiedene Speicherelemente mit verschiedenen (minimalen) Zugriffszeiten innerhalb des Speichers eingesetzt werden. Die Speicherelemente (z. B. Speicherchips oder Speichermodule oder Bereiche einzelner Speicherchips) werden dabei so verteilt, daß die schnellen Speicherelemente jeweils die ersten Datenelemente der Speicherblöcke empfangen. Beim Auslesen eines Datenblocks muß daher zuerst zu diesen schnellen Speicherelementen zugegriffen werden, die dann nach kurzer Zeit das erste Datenelement des Blocks liefern. Die übrigen, langsamen Speicherelemente, in denen die restlichen Daten eines Blocks gespeichert sind, können gleichzeitig oder zeitlich gestaffelt nach der Leseanforderung des schnellen Speicherelements angesprochen werden, so daß eine zeitliche Überlappung des Betriebs der Speicherelemente auftritt und die restlichen Datenelemente sehr schnell hintereinander ausgelesen werden können. Insgesamt verhält sich der so aus Speicherelementen verschiedener Leistungsfähigkeit aufgebaute Digitalspeicher wie ein homogener Speicher mit sehr kurzer Zugriffzeit und sehr hoher Datenrate. Da andererseits nur relativ wenige schnelle (und damit teure) Speicherelemente erforderlich sind und der Großteil des Speichers aus langsamen (und billigen) Speicherelementen besteht, ergibt sich insgesamt ein sehr günstiger Gesamtpreis; außerdem ist für den gesamten zusammengesetzten Speicher nur eine Adressiereinrichtung erforderlich.

Eine bevorzugte Anwendung dieses Speichers betrifft seine Verwendung als Hauptspeicher in einem Cache-System, bei dem jeweils ganze Cache-Blöcke (sog. Cache-Linien) aus dem Hauptspeicher in den Cache übertragen werden, unabhängig davon, welches Element innerhalb des Cache-Blocks vom Prozessor gerade angefordert wurde. In diesem Fall liegt also das oben beschriebene, gewünschte Zugriffsmuster für die Daten vor, so daß die Verteilung der Anfangselemente aller Cache-Blöcke auf die schnellen Speicherelemente ohne Schwierigkeiten erfolgen kann.

Durch den Einsatz wenig leistungsfähigen Speicherelemente ohne Leistungsverlust für das Gesamtsystem können auch solche Speicherelemente verwendet werden, die sonst bei der Produktion zurückgewiesen werden müßten. Der hier vorgeschlagene Digitalspeicher kann auch in kleineren Rechner eingesetzt werden, da er keinen zusätzlichen internen Verwaltungsaufwand erfordert und überall verwendbar ist, wo Daten in Blockform aus dem Speicher ausgelesen werden oder andere, von vornherein bekannte Adreßverteilungen der Speicherzugriffe vorliegen.

Ein Ausführungsbeispiel der Erfindung wird nun anhand von Zeichnungen näher erläutert; es zeigen:

Fig. 1    die schematische Darstellung eines Digitalspeichers mit Abschnitten verschiedener Zugriffszeiten und gemeinsamer Ansteuerung,

Fig. 2    ein schematisches Zeitdiagramm für das Auslesen eines Datenblocks aus einem üblichen Speicher und einem Speicher nach der vorliegenden Erfindung,

Fig. 3    die Zuordnung zwischen dem linearen Adreßraum eines Hauptspeichers und den in einem vorgeschalteten Cache-Speicher enthaltenen Datenblöcken,

Fig. 4A    den schematischen Aufbau eines Hauptspeichers mit Speicherchips, die unterschiedliches Zeitverhalten aufweisen und die Datenblöcke speichern, die in einen Cache-Speicher entsprechend Fig. 3 übertragen werden,

Fig. 4B    das Zeitdiagramm für den Betrieb des Speichers nach Fig. 4A,

Fig. 5A    die schematische Darstellung des inneren Aufbaus eines Speicher-Halbleiterplättchens mit unterschiedlichen Gebieten kleiner bzw. längerer Zugriffszeiten,

Fig. 5B    den schematischen Aufbau eines Digitalspeichers mit Speicherchips nach Fig. 5A,

Fig. 5C    das Adreßfeld zur Adressierung eines Digitalspeichers nach Fig. 5B.

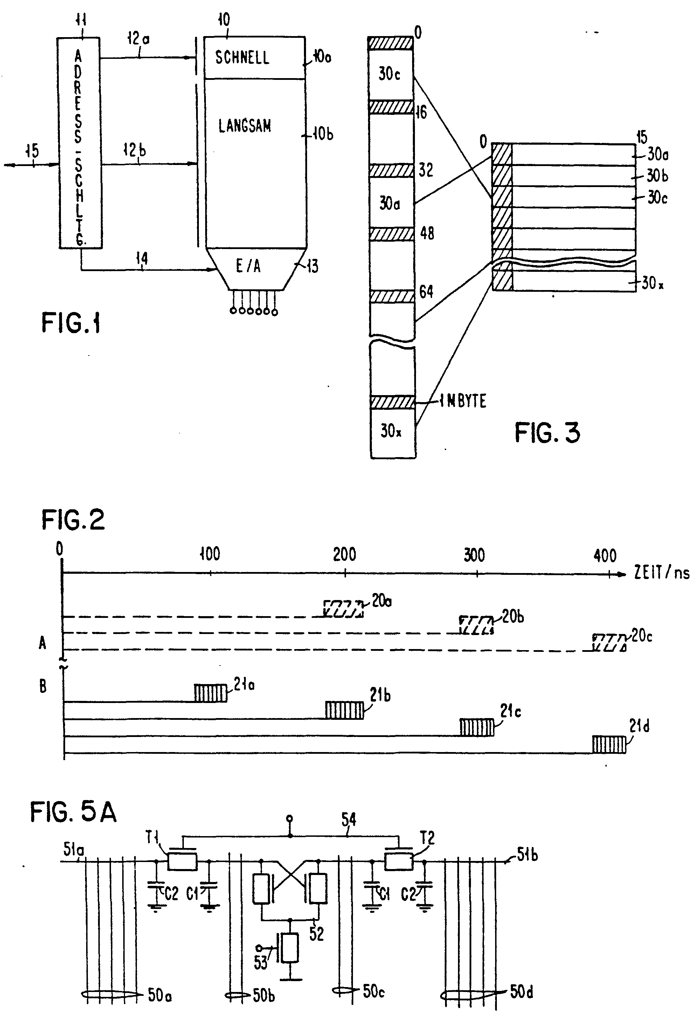

In Fig. 1 ist der prinzipielle Aufbau eines Digitalspeichers dargestellt, der aus mindestens zwei Teilen aufgebaut ist, die unterschiedliches Zeitverhalten bezüglich der Speicherzugriffe aufweisen und von einer gemeinsamen Steuer- und Adressierlogik angesprochen werden. Im ersten, kleineren Teil 10a des Speichers 10 sind Speicherelemente enthalten, die einen schnelleren Zugriff zur gespeicherten Information gestatten als die Speicherelemente im Teil 10b; beispielsweise können im Teil 10a Speichermodule mit einem einzelnen oder mehreren Speicherchips enthalten sein, die eine kurze Zugriffszeit aufweisen, oder es können für beide Teile 10a, 10b dieselben Speicherchips verwendet werden, wenn auf dem einzelnen Chip jeweils ein (kleinerer) Abschnitt mit kurzer Zugriffszeit und ein (größerer) Abschnitt mit längerer Zugriffszeit vorhanden ist. Die schematische Aufteilung der Abschnitte nach Fig. 1 entspricht also der logischen Aufteilung im Sinne der Adreßunterscheidung und weniger der physikalischen Unterscheidung nach Art der Speicherchips. Für beide Teile 10a, 10b ist eine gemeinsame Steuer- und Adreßschaltung 11 vorgesehen, die jeweils getrennte Selektierungssignale für die Teile 10a, 10b liefert (oder auch über entsprechende mehradrige Adreßleitungen 12a, 12b). Die Ein- und Ausgabe von Daten zum Speicher erfolgt über übliche Eingabe/Ausgabeschaltungen 13, die über Leitungen 14 Steuerinformation von der Steuer- und Adreßschaltung 11 erhalten. Ober Leitungen 15 steht die Steuer- und Adreßschaltung 11 mit dem Prozessor in Verbindung, von dem sie beispielsweise einen Lesebefehl und die zugehörige Adresse empfängt.

Um bei der hier vorgeschlagenen Aufteilung eines von gemeinsamen Adressiervorrichtungen beaufschlagten Speichersystems in schnell reagierende und weniger schnell reagierende Abschnitte muß sichergestellt sein, daß die Mehrzahl der Zugriffe zu den schnellen Abschnitten erfolgt (diese also die am häufigsten angesprochenen Daten und/oder Instruktionen enthalten) oder aber, daß die schnellen und die langsamen Speicherabschnitte überlappt betrieben werden und die jeweils ersten Zugriffe in den schnellen Abschnitt erfolgen. Die erstgenannte Möglichkeit erfordert die Kenntnis der Zugriffshäufigkeit zu den einzelnen gespeicherten Informationen. Da diese von Programm zu Programm stark unterschiedlich sind, kann die hier ermöglichte Geschwindigkeitserhöhung des Gesamtspeichers nur dann erreicht werden, wenn der Benutzer selbst die Daten entsprechend ihrer Benutzungshäufigkeit auf die einzelnen Speicherabschnitte verteilt.

Eine Geschwindigkeitserhöhung des Gesamtspeichers ohne jede Intervention läßt sich andererseits erreichen, wenn nicht einzelne Zugriffe zum Speicher betrachtet werden, sondern größere Datenblöcke, die in den Speicher ein- bzw. aus ihm ausgelesen werden. Wo immer derartige Blockübertragungen auftreten, kann das Geschwindigkeitspotential eines Speichers mit mehreren Abschnitten ausgenutzt werden, sofern es gelingt, die ersten Datenelemente aller Blöcke in den schnellen Abschnitten des Speichers unterzubringen.

Fig. 2 zeigt in einem Zeitdiagramm den Zeitgewinn eines derartig aufgebauten Speichers im Vergleich mit einem Speicher, der ausschließlich aus Speicherelementen aufgebaut ist, die im langsameren Abschnitt des erfindungsgemäßen Speichern enthalten sind. Haben beispielsweise diese langsameren Speicherelemente eine Zugriffszeit von 200 ns und beträgt die Zugriffszeit der schnelleren Speicherelemente 100 ns, so erscheint bei einem konventionellen Speicher (Zeile A) das erste ausgelesene Datenelement 20a nach 200 ns am Ausgang des Speichers; da ein gesamter Block auszulesen ist, wurde zeitlich überlappt mit dem Zugriff zum ersten Datenelement 20a das Auslesen des zweiten Datenelements 20b vorbereitet, so daß dieses bereits 100 ns nach dem ersten Datenelement zur Verfügung steht. Entsprechendes gilt für die weiteren Datenelemente 20c usw, zu denen ebenfalls überlappt zugegriffen werden kann, da die einzelnen Speicherelemente (z. B. Chips) unabhängig voneinander betrieben werden können.

Erfolgt dagegen der Zugriff zum ersten Datenelement 21a im schnellen Abschnitt (10a) des Speichers, so erscheint dieses Datenelement schon nach 100 ns am Ausgang des Speichers; die nachfolgenden Datenelemente werden wie im erstgenannten Fall zeitlich überlappt angesprochen, so daß wiederum nach jeweils 100 ns ein weiteres Datenelement zur Vefügung steht, bis der gesamte Block ausgelesen ist.

Durch die Plazierung der ersten Datenelemente eines Blocks in den schnellen Speicherabschnitten erfolgt in diesem Beispiel also eine Reduzierung der ersten Zugriffszeit um die Hälfte; der Anteil der schnellen Speicherelemente am Gesamtspeicher richtet sich dabei nach der Anzahl der Datenelemente in einem Block und kann bei großen Datenblöcken somit sehr klein werden.

Ein wichtiger Fall der Datenübertragung in Blöcken erfolgt innerhalb von Speicherhierarchien, beispielsweise zwischen einem Cache-Speicher und seinem zugeordneten Hauptspeicher. Ist dort bei einer Prozessoranforderung das gewünschte Datenelement (z. B. ein Byte) nicht im Cache-Speicher enthalten, liegt also ein Cache-Fehltreffer vor, so muß das Datenelement in den Cache-Speicher übertragen werden. Da eine hohe Wahrscheinlichkeit besteht, daß benachbarte Datenelemente später ebenfalls vom Prozessor benötigt werden, erfolgt die Übertragung des gesuchten Bytes in den Cache zusammen mit dem gesamten Block, in dem dieses Byte enthalten ist.

Fig. 3 zeigt schematisch ein derartiges Beispiel von Cache-Blöcken 30a bis 30x, die jeweils aus 16 Bytes bestehen; das erste Byte oder die erste Gruppe von Bytes eines jeden Cache-Blocks ist schraffiert dargestellt. Für jeden dieser Cache-Blöcke ist im Hauptspeicher ein Duplikat vorhanden. Auf der linken Seite von Fig. 3 ist beispielsweise der logisch fortlaufende Adreßraum eines Ein-Megabyte-Hauptspeichers dargestellt, aus dem die Cache-Blöcke 30a bis 30x mit je 16 Bytes entnommen sind. Die Blöcke beginnen in diesem Adreßraum jeweils auf einer durch 16 teilbaren Adresse, so daß die Hauptspeicheradressen der ersten Datenelemente aller möglichen Cache-Blöcke bekannt sind. Diese Adressen sind auf der linken Seite von Fig. 3 ebenfalls schraffiert dargestellt.

Das für die oben beschriebene Geschwindigkeitserhöhung eines aus mehreren Abschnitten bestehenden Speichers erforderliche Zugriffsmuster läßt sich nun für einen Cache-Speicher nach Fig. 3 erreichen, wenn alle durch 16 teilbaren Hauptspeicheradressen (schraffiert dargestellt) im schnellen Abschnitt des Speichers untergebracht werden können.

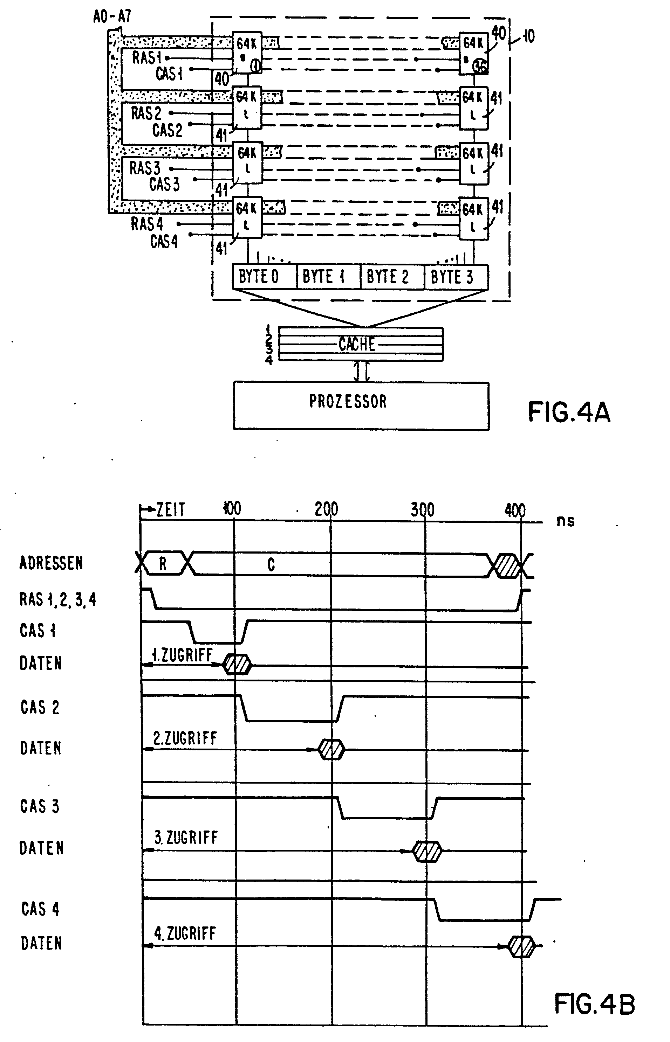

Fig. 4A zeigt den Aufbau eines Hauptspeichers 10, mit dem diese Forderung erfüllt werden kann. Der Speicher weist eine Gesamtkapazität von einem Megabyte auf und besteht aus einer Matrix von 36 x 4 Speicherchips, von denen jedes 64 Kilobits enthält und nach der sog. 64 K x 1 Bit-Organisation aufgebaut ist (d. h. jedes Bit kann einzeln adressiert werden). Die erste Reihe mit 36 Chips 40 besteht aus schnellen Speicherchips mit einer Zugriffszeit von 100 ns (wie sie beispielsweise heute ohne weiteres mit dynamischen Feldeffekttransistor Speichern (FET-Speichern) erreicht werden kann); die übrigen drei Reihen bestehen aus FET-Speicherchips 41 mit einer Zugriffszeit von 200 ns, deren Herstellungskosten günstiger sind. Die 36 Speicherchips in jeder Reihe erlauben das gleichzeitige Auslesen von 36 Bits, entsprechend vier Bytes zu je acht Bits und vier Prüf- oder Paritätsbits. Die Speicher einer Reihe werden alle mit gleichen Chipauswahlsignalen RAS (Row Address Selection) und CAS (Column Address Selection) adressiert. Diese Signale werden von der Speichersteuer und -adressiereinheit 11 in Fig. 1 erzeugt und werden hier nicht näher beschrieben, da sie im Stand der Technik bekannt sind. Da jeder Datenblock im Cache aus 16 Bytes besteht, müssen insgesamt vier Gruppen von jeweils 4 Bytes ausgelesen werden, so daß nach jeweils 100 ns eine weitere Gruppe von 4 Bytes am Speicherausgang zur Verfügung steht.

Das Zeitdiagramm für die Ansteuerung des Speichers nach Fig. 4A ist in Fig. 4B wiedergegeben. Die aus insgesamt 16 Bits bestehende Adresse (zum Adressieren von 64 K Blöcken mit jeweils 16 Bytes eines Cache-Blocks, der in vier Gruppen zu 4 Bytes ausgelesen wird) wird in zwei Teilen an den Speicher angelegt. Die oberste Zeile von 4B zeigt, daß die erste Adreßgruppe R zuerst angelegt wird, um innerhalb des Speichersystems für den gesamten Zugriff verriegelt zu werden (durch die Signale RAS 1, 2, 3, 4). Anschließend wird nach kurzer Zeit (ungefähr 50 ns) die zweite aus 8 Bits bestehende Gruppe C der Adreßbits angelegt, die während des restlichen Zugriffszyklus auf den Adreßleitungen stehen bleibt und mit den zeitlich nacheinander erscheinenden Signalen CAS 1 bis CAS 4 den Auslesevorgang bestimmt. Das jeweilige CAS Signal verschwindet, wenn ein Datenblock mit 4 Bytes (schraffiert dargestellt) am Ausgang des Speichers zur Verfügung steht. Das erste Signal CAS 1 ist ein sogenanntes schnelles CAS Signal, das zur Auswahl eines der schnellen Speicherchips dient. Die Erzeugung der verschiedenen CAS Signale ist Aufgabe der Speichersteuer- und -adressiereinheit 11, deren Schaltkreise zur Erzeugung des ersten schnellen CAS Signals entsprechend ausgelegt werden müssen. Wird die Speichersteuer- und -adressiereinheit nicht geändert, so kann der hier vorgeschlagene Speicher auch ohne weiteres in der Art eines herkömmlichen Speichersystems betrieben werden.

Der Nettoeffekt für den Benutzer eines Speichersystems der hier vorgeschlagenen Art besteht also darin, daß ein gesamter aus mehreren Bytes bestehender Datenblock so zur Verfügung gestellt wird, als käme er aus einem Speicher, der insgesamt aus schnelleren Speicherelementen aufgebaut ist. Das Signal "Daten bereit", das üblicherweise vom Speichersystem an den Benutzer abgegeben wird, erscheint also zu einer relativ frühen Zeit.

Die physikalische Speicherorganisation nach Fig. 4A mit Speicherchips unterschiedlichen Zeitverhaltens entspricht also der logischen Zuordnung von Cache-Blöcken zum Adreßraum des Hauptspeichers, wie sie anhand von Fig. 3 erläutert wurde. Da bei einer Gesamtkapazität des Hauptspeichers von einem Megabyte und einer Blockgröße von 16 Bytes insgesamt 64 K Blöcke vorhanden sind und das erste Datenelement jedes Blocks, das mit einem Zugriff ausgelesen wird, aus vier Bytes besteht, müssen in der ersten (schnellen) Speicherzeile von Fig. 4 insgesamt 64 K x 4 x 8 Bits = 32 Chips a 64 K Bits vorhanden sein (zusätzlich kommen noch 4 Chips für das Paritätsbit in jedem Byte dazu).

Die in Fig. 4A dargestellte physikalische Realisierung eines Speichers für den schnellen Zugriff zu Datenblöcken ist nicht die einzig möglich denkbare; statt nur einer "schnellen" Zeile können auch mehrere vorgesehen sein und/oder schnelle Spalten. Das optimale Verhältnis zwischen der Kapazität schneller und langsamer Speicherabschnitte wird bestimmt durch die Größe der Blocks, die Verteilung der beiden Abschnitte im Gesamtspeicher, das Verhältnis der Zugriffszeiten langsamer und schneller Speicherelemente, deren Preis usw.

In einer weiteren Ausgestaltung der Erfindung können anstelle verschiedener Speicherchips, die insgesamt unterschiedliche Zugriffszeiten aufweisen, auch strukturierte Speicherchips verwendet werden, die in sich Abschnitte mit kurzer und Abschnitte mit langer Zugriffszeit aufweisen. Ein Beispiel für die Realisierung derartiger Chips ist in Fig. 5A dargestellt. Dort wird von der Tatsache Gebrauch gemacht, daß die Zugriffszeit innerhalb eines Chips sehr stark von den Streukapazitäten der Ansteuerungsleitungen zu den einzelnen Speicherknoten (Speicherzellen) abhängt. Ein Chip mit vielen Speicherzellen benötigt lange Leitungen mit entsprechend großen Streukapazitäten zur Adressierung der einzelnen Zellen. Zur Reduzierung dieser Kapazitäten wird nun vorgeschlagen, in diese Leitungen Sperrtransistoren einzubauen, die von der Speichersteuerung betätigt werden können, um Teile der Leitungen abzuschalten und somit deren Kapazität unschädlich zu machen. Zu den nicht abgeschalteten Teilen des Speichers kann dann mit höherer Geschwindigkeit zugegriffen werden. Eine Halbleiterspeichereinheit mit Sperrtransistoren in den Bitleitungen ist z. B. in der JP-A-5 558 891 beschrieben.

In Fig. 5A sind zur Vereinfachung der Darstellung die einzelnen Speicherknoten weggelassen und nur schematisch einige Wort- und Bitleitungen angegeben. Der Speicher ist symmetrisch aufgebaut und enthält Bitleitungen 51a, 51b, die an eine Ausleseschaltung 52 angeschlossen sind, der über eine Leitung 53 Setzsignale zugeführt werden können. In die Bitleitungen sind Transistoren T1, T2 eingebaut, die gemeinsam über eine Ansteuerleitung 54 geschaltet werden können. Werden die Transistoren T1, T2 ausgeschaltet, so bleibt die Ausleseschaltung 52 unbeeinflußt von Kapazitäten C2 der Wortleitungen 50a, 50d, die hinter diesen Transistoren liegen. Das Speicherchip wird dadurch auf die Wortleitungsgruppen 50b, 50c reduziert, die eine wesentlich kleinere Kapazität C1 aufweisen und somit wesentlich schneller betrieben werden können als das gesamte Speicherchip. Die Wortleitungen 50b, 50c entsprechen somit funktionell den schnellen Speicherchips der ersten Zeile in Fig 4A. Die Adressierung der schnellen bzw. langsamen Speicherbereiche auf diesem Chip erfolgt wieder durch die Speichersteuer- und -adressiereinheit.

Die Geschwindigkeitserhöhung für den schnellen Abschnitt eines Speicherchips nach Fig. 5A läßt sich noch verbessern, wenn entsprechende Sperrtransistoren auch in die Dekodierer der Speicherchips eingebaut werden, um den nicht benötigte Teil der Dekodiereinrichtungen (z. B. des binären Dekodierbaumes) samt seiner schädlichen Kapazitäten abzutrennen, wenn nur ein Zugriff zum schnellen Teil 50b, 50c des Chips gewünscht wird. Die Aktivierung der Sperrtransitoren, z. B. T1, T2 kann auch durch einen Vorimpuls erfolgen, der vom Rechner geliefert wird.

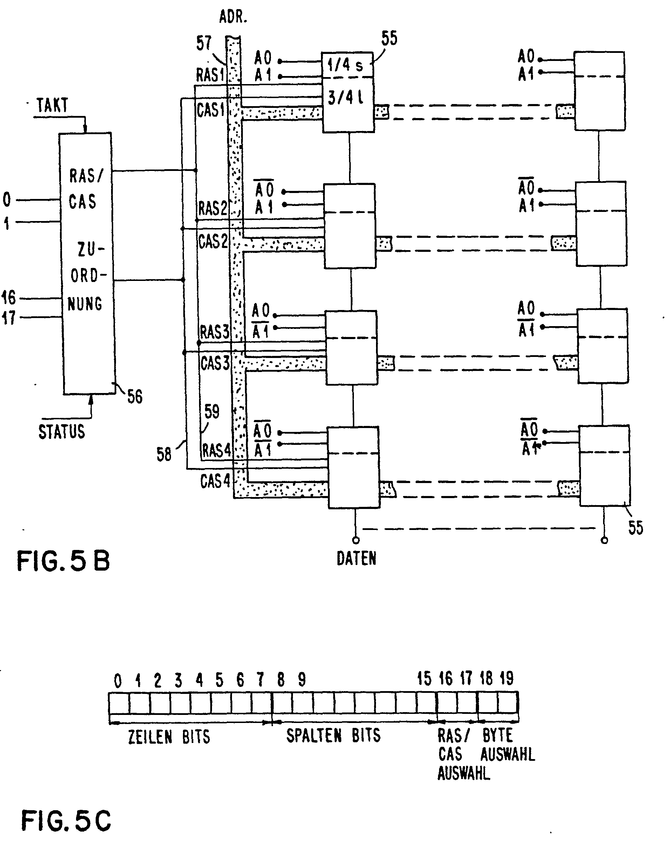

Fig. 5B zeigt in schematischer Weise den Aufbau einer Speicheranordnung mit Speicherchips 55 nach Fig. 5A, die aus einem kleineren schnellen Teil (s) und einem größeren langsamen Teil (1) bestehen. Im Speicher nach Fig. 5B mit vier Zeilen von Speicherchips entspricht der schnellere Teil eines Chips gerade einem Viertel der Gesamtkapazität des Chips. Wie im Speichersystem nach Fig. 4A werden die Adreßbits in zwei Gruppen (A2-A7 bzw. A8-A15) nacheinander über die Adreß-Sammelleitung 57 an die einzelnen Chips angelegt. Die Adreßbits A0 und A1 werden direkt den schnellen Abschnitten der einzelnen Speicherchips zugeführt, und zwar der ersten Chipzeile direkt (A0, A1) , der zweiten Chipzeile in der Form Ā0, A1, wobei Ā0 das invertierte Signal A0 bedeutet, der dritten Chipzeile in der Form A0, Ā1 und der vierten Chipzeile in der Form Ā0, Ā1. Da aber jetzt alle Speicherchips schnelle CAS Signale erfordern (wenn nämlich ihr schneller Speicherteil adressiert ist), muß die Zuordnung des schnellen CAS Signals adreßabhängig erfolgen. Dazu werden die Bits 16 und 17 der Adresse verwendet, die nach Fig. 5C aus insgesamt 20 Adreßbits besteht, entsprechend der angenommenen Gesamtkapazität des Speichers von einem Megabyte; die letzten beiden Bits dienen zur Byte-Auswahl und werden beim Auslesen von 4-er Blöcken nicht benötigt. Die beiden Bits 16, 17 bestimmten eindeutig die Zeile von Speicherchips, die für den betreffenden Auslesevorgang mit dem schnellen CAS Signal beaufschlagt werden soll. Die weiteren Speicherzugriffe zum Auslesen eines gesamten Blockes erfolgen dann wie bisher beschrieben durch Zugriffe zu den langsameren Chipteilen mit entsprechender Adreßsteuerung durch die oben angegebenen vier Bits.

Die Erzeugung der RAS und CAS Signale erfolgt in einer Schaltung 56 innerhalb der Speichersteuer- und -adressiereinheit 11; die Eingänge der Schaltung 56 empfangen die Adreßbits 16 und 17 sowie Status- und Taktsignale. Die einzelnen Signalleitungen 58, 59 zu den Speicherchips werden von den Ausgängen der Schaltung 56 mit den für den jeweiligen Speicherzugriff erforderlichen RAS Signalen und den schnellen oder langsamen CAS Signalen beaufschlagt.

In der Schaltung 56 können z. B. Schieberegister eingesetzt werden, um eine zyklisch fortlaufende Zuordnung des schnellen CAS Signals zu den Chipzeilen zu realisieren.

Eine Verallgemeinerung der Zugriffssequenz läßt sich erzielen, wenn nicht nur die CAS Signale adreßabhängig erzeugt werden, sondern auch die RAS Signale. Dies ist z. B. erforderlich, wenn mehrere schnelle Speicherzugriffe hintereinander erfolgen sollen. In dieser verallgemeinerten Form erhält die Schaltung 56 auch noch die Adreßsignale A0 und A1 zugeführt.

**Patentansprüche**

1. Digitalspeicher mit mehreren Speicherelementen und einer gemeinsamen Adressier- und Steuerschaltung,
dadurch gekennzeichnet,
daß ein Teil der Speicherelemente (10a) eine kürzere minimale Zugriffszeit aufweist als die übrigen Speicherelemente (10b) und daß die Adressier- und Steuerschaltung (11) adressabhängig zeitlich unterschiedliche Auswahlsignale (CAS) für die beiden Arten von Speicherelementen erzeugt.

2. Digitalspeicher nach Anspruch 1,
dadurch gekennzeichnet,
daß die Speicherelemente komplette Speicherchips (40) sind.

3. Digitalspeicher nach Anspruch 2,
dadurch gekennzeichnet,
daß Speicherchips (40 bzw. 41) mit jeweils unterschiedlichen Zugriffszeiten verwendet werden.

4. Digitalspeicher nach Anspruch 2,
dadurch gekennzeichnet,
daß Speicherchips verwendet werden, deren Zugriffszeit von der an das Chip angelegten Adresse abhängt.

5. Digitalspeicher nach Anspruch 4,
dadurch gekennzeichnet,
daß in die Wortleitungen der Speicherchips Sperrtransistoren (T1, T2; Fig. 5A) eingebaut sind, die adreßabhängig betätigt werden.

6. Digitalspeicher nach einem der Ansprüche 1 bis 5,
dadurch gekennzeichnet,
daß zur Übertragung von Datenblöcken mehrere Speicherzugriffe hintereinander und überlappt durchgeführt werden und daß der jeweils erste Speicherzugriff zu einem Speicherchip mit kurzer Zugriffszeit erfolgt.

7. Digitalspeicher nach Anspruch 6,
dadurch gekennzeichnet,
daß mehrere Speicherabschnitte (Chipzeilen) vorgesehen sind, die jeweils parallel betätigt werden und daß zu einem vollständigen Speicherzugriff die Speicherabschnitte nacheinander betätigt werden.

8. Digitalspeicher nach Anspruch 7,
dadurch gekennzeichnet,
daß einer der Speicherabschnitte ausschließlich aus Speicherelementen mit kurzer Zugriffszeit besteht.

9. Digitalspeicher nach Anspruch 7,
dadurch gekennzeichnet,
daß alle Speicherabschnitte mindestens ein Speicherelement mit kurzer Zugriffszeit enthalten.

10. Verwendung eines Digitalspeichers nach einem der Ansprüche 6 bis 9 in einer Speicherhierarchie aus verschiedenen Speichertypen mit blockweiser Datenübertragung zwischen den einzelnen Hierarchieebenen, wobei der Beginn jedes Datenblocks in Speicherelementen mit kurzer Zugriffszeit gespeichert ist.

## Claims

1. Digital storage with several storage elements and a common address and control circuit, characterized in that part of the storage elements (10a) have a shorter minimum access time than the remaining storage elements (10b), and that selection signals (CAS) which are different in time depending upon the address are generated by the address and control circuit (11) for the two kinds of storage elements.

2. Digital storage according to claim 1, characterized in that the storage elements are complete storage chips (40).

3. Digital storage according to claim 2, characterized in that storage chips (40 and 41, respectively) with different access times are used.

4. Digital storage according to claim 2, characterized in that storage chips are used whose access time depends on the address applied to the chip.

5. Digital storage according to claim 4, characterized in that the word lines of the storage chips comprise blocking transistors (T1, T2; Fig. 5A) which are actuated depending upon the respective address.

6. Digital storage according to any one of the claims 1 to 5, characterized in that for transferring data blocks, several storage access operations are successively performed overlapping in time, and that the respective first storage access operation is effected to a storage chip with a short access time.

7. Digital storage according to claim 6, characterized in that several storage sections (chip rows) are provided which are each operated in parallel, and that for a complete storage access cycle, the storage sections are successively operated.

8. Digital storage according to claim 7, characterized in that one of the storage sections exclusively consists of storage elements with a short access time.

9. Digital storage according to claim 7, characterized in that all storage sections comprise at least one storage element with a short access time.

10. Use of a digital storage according to any one of the claims 6 to 9 in a storage hierarchy of different storage types with block-by-block data transfer between the individual hierarchy levels, the start of each data block being stored in storage elements with a short access time.

## Revendications

1. Une mémoire numérique comprenant une pluralité d'éléments de mémoire et un circuit de commande et d'adressage commun, caractérisée en ce qu'une partie des éléments de mémoire (10a) présente un temps d'accès minimal plus faible que celui des autres éléments de mémoire (10b) et en ce que le circuit de commande et d'adressage (11) délivre aux deux types d'éléments de mémoire des signaux de sélection (CAS) fonction de l'adresse différents dans le temps.

2. La mémoire numérique de la revendication 1, caractérisée en ce que lesdits éléments de mémoire sont des microcircuits de mémoire complets (40).

3. La mémoire numérique de la revendication 2, caractérisée en ce que les microcircuits de mémoire (40 ou 41) ont des temps d'accès respectifs différents.

4. La mémoire numérique de la revendication 2, caractérise en ce que l'on utilise des microcircuits de mémoire dont le temps d'accès dépend de l'adresse appliquée au microcircuit.

5. La mémoire numérique de la revendication 4, caractérisée en ce que des transistors de verrouillage (T1, T2 ; figure 5A) sont placés dans les lignes de mot des microcircuits de mémoire, ces transistors étant commandés en fonction de l'adresse.

6. La mémoire numérique de l'une des revendications 1 à 5, caractérisée en ce que, pour transférer des blocs de données, on exécute plusieurs accès mémoire successifs et avec chevauchement dans le temps, et en ce que le premier accès mémoire correspondant dans un microcircuit de mémoire est effectué avec le faible temps d'accès.

7. La mémoire numérique de la revendication 6, caractérisée en ce qu'il est prévu plusieurs sections de mémoire (rangées de microcircuits) commandées chacune en parallèle, et en ce que, pour un accès complet à la mémoire, les sections de mémoire sont activées l'une après l'autre.

8. La mémoire numérique de la revendication 7, caractérisée en ce que l'une des sections de mémoire est composée exclusivement d'éléments de mémoire à faible temps d'accès.

9. La mémoire numérique de la revendication 7, caractérisée en ce que toutes les sections de mémoire comprennent au moins un élément de mémoire à faible temps d'accès.

10. L'utilisation d'une mémoire numérique selon l'une des revendications 6 à 9 dans une mémoire hiérarchisée ayant des mémoires de types différents avec transfert par blocs des données entre les différents niveaux hiérarchiques, dans laquelle le début de chaque bloc de donnée est mémorisé dans des éléments
de mémoire à faible temps d'accès.

FIG.1

FIG. 3

FIG.2

FIG. 5A

FIG.4A

FIG.4B

FIG. 5 B

FIG. 5C